# EUROPEAN PATENT SPECIFICATION

(11) **EP 0 487 484 B1**
(45) Date of publication and mention of the grant of the patent: **25.01.1995**
(21) Application number: 91870174.9
(22) Date of filing: 06.11.1991
(51) Int. Cl.: H04B 1/20, H03G 1/02, H04S 7/00

(54) **Improvement to the controls of vehicle audio/video apparatuses**
Verbesserungen für die Kontrolle eines Audio/Video-Geräts für Fahrzeuge
Perfectionnements aux commandes d'appareils audio/vidéo pour véhicules

(30) Priority: 19.11.1990 BE 9001088
(43) Date of publication of application: 27.05.1992
(73) Proprietor: STAAR SOCIETE ANONYME, B-1200 Bruxelles (BE)
(72) Inventor: d'Alayer de Costemore d'Arc, Stéphane Marie André, B-1474 Ways (BE)
(74) Representative: Overath, Philippe

(56) References cited:
- EP-A- 0 373 387
- GB-A- 2 188 458

## Description

The present invention relates to audio/video apparatuses and more precisely to those, such as radio apparatuses, radio cassettes,video cassettes, etc., intended to be installed in motor vehicles.

It relates more particularly to the controls of the said apparatuses ensuring the various functions and in particular the setting of several parameters or functions such as the sound volume, the bass and treble level, the stereophonic balance, the balancing of the front and rear loudspeakers (fade),etc.

In fact, in the apparatuses of the kind described here-above, one can observe either a profusion of control knobs, or the appearance of controls enabling several functions controlled by a single adjustment knob associated with a knob selecting said functions, the labelling of which is then displayed on a control panel located on the front panel of the apparatus.

As it is easily understood, these solutions are not satisfactory for apparatuses used in vehicles since the user, who in most cases is the driver, must momentarily distract his attention from the road and turn it to the apparatus so as to either determine the knob which he must manipulate, or read the information displayed on the control panel so as to be assured that the desired function is indeed the one selected.

Moreover, when there is a change of driver and consequently of user (company cars, rented vehicles, etc.), the latter rarely consults the instructions manual of the apparatus before driving and consequently he must find out how the apparatus operates at the same time he is driving.

As it is easily appreciated, such solutions are dangerous with regards to driving motor vehicles.

To deal with these drawbacks, one manufacturer has just offered on the market an apparatus incorporating a device for recognizing the adjustment orders given vocally by the user.

However, such a device requires that the user previously records the orders in such a manner that the apparatus be able to recognize his instructions and carry out the appropriate adjustments.

Such means very substantially increase the price of the apparatus and are thus not appropriate for apparatuses aimed at a wide distribution. In addition, their implementation is very complicated for the average consumer while the apparatus can be controlled by a single user only.

A prior art arrangement for controlling a vehicle-mounted audio device in known from EP-A- 0 373 387.

The aim of the present invention is therefore to cope with the above-mentioned disadvantages by offering simple and efficient means permitting the user to select and actuate the desired control without having to distract his attention from the road, said means being excessively easy to manipulate and economical to implement so as not to increase the cost of the apparatus in which they are incorporated.

To realize this aim, the improvement according to the present invention is essentially characterized by the content of the first claim.

Various advantages and characteristics of the invention will appear from the description of a preferred embodiment given hereinafter by way of non-limiting example, and for which :
- Figure 1 is a front view of a car radio-cassette apparatus incorporating the improvement,
- Figure 2 represents a block diagram of the circuit incorporated in the apparatus represented at Figure 1 along the preferred embodiment,
- Figure 3 is a diagram of a program of prerecorded instructions enabling the implementation of the device subject of the invention.

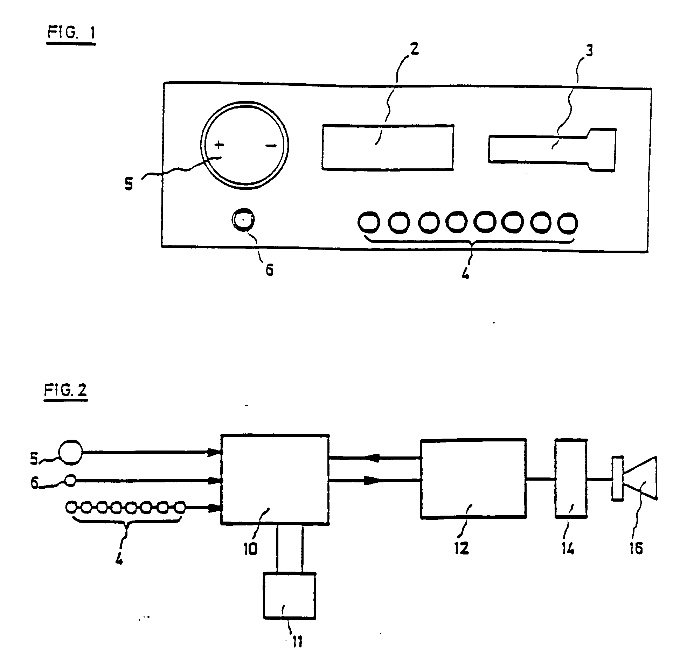

As shown in Figure 1, a car radio-cassette player generally comprises a display panel 2, a slot 3 permitting the insertion of a cassette into the playing mechanism or its ejection, a range of knobs 4 permitting the selection of various radio wavebands and eventually the storage of preferred broadcasting stations.

Furthermore, the apparatus comprises an adjustment control 5 associated with a function selecting control 6.

As shown in Figure 2, the electronic circuit of an apparatus, such as the one represented in Figure 1, comprises among others :
- a control unit 10, which is a microprocessor executing prerecorded instructions contained in its (internal or external) memory ;
- a so-called adjustment circuit 12 of the "SOFAC" type ensuring the various adjustments and functions of the apparatus (volume - bass and treble level - stereophonic balance, front/rear loudspeaker balance - etc.);
- a circuit 14 for preamplifying and amplifying the signal to be reproduced and to which are connected one or more loudspeakers 16.

In the units available from the market, the knobs controlling the functions and various adjustments of the apparatus are linked to the control unit 10 or to the circuit 12 depending on whether or not an intercommunication bus exists between these two circuits.

In the prototype working out the invention, the device which is the object of the invention has been incorporated into a Philips car radio-cassette bearing the reference n° 22DC774. For further details relating to the circuit of this apparatus and more specifications concerning the interface between the said apparatus and the device of the invention, reference will advantageously be made to the "Technical Manual" published by the manufacturer. This apparatus incorporating the "I²C Bus" intercommunication system, the various adjustment and function controls 4, 5 and 6 are connected to the inputs of the control unit 10.

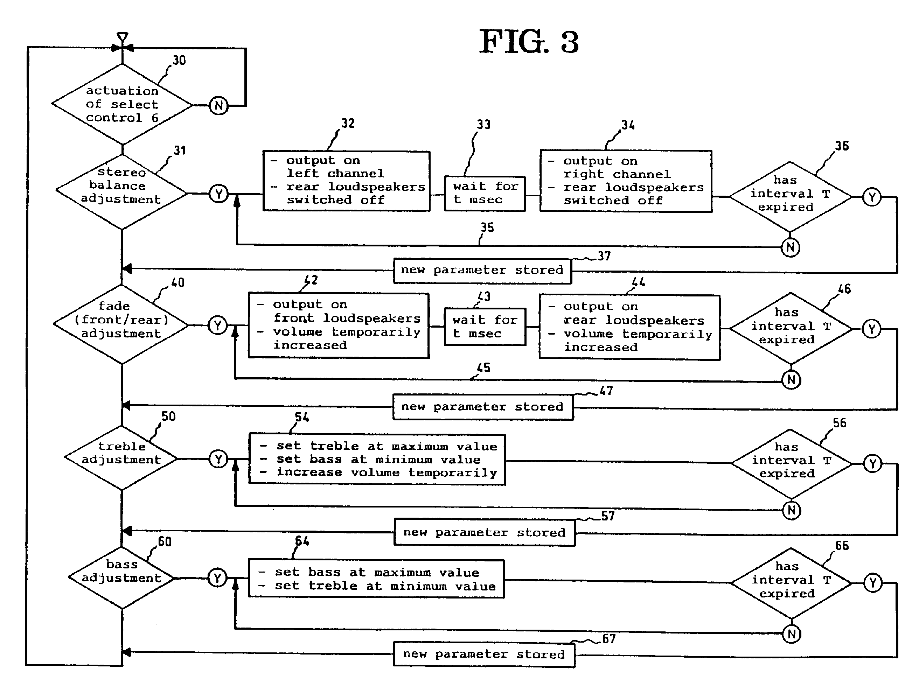

The control unit 10 storing the prerecorded instructions incorporates the program implementing the device according to the invention, the block diagram of which is shown at Figure 3.

Upon switch on of the apparatus, the control unit 10 is actuated and reads out on its inputs the eventual actuation of any one of the adjustment or function controls and especially an actuation 30 (figure 3) of the function selecting control 6. Simultaneously, the control unit 10 actuates and executes the program of prerecorded instructions carrying out the simulating 11 stored in the corresponding memory of the various functions.

As long as the control 6 is not actuated, the function of the adjustment control 5, is to control the sound volume which can be increased or decreased at will by the user.

This function is chosen because of its frequency of use but it is easily understood that any other priority function can be chosen arbitrarily.

A first actuation 31 of the function selecting control 6 ensures the powering of the stereophonic balance adjustment mode (Figure 3).

In order that the user recognize, without having to distract his attention from the road, that this function is powered, the simulating 11 automatically enables, by acting on the circuit 12, a variation of the stereophonic balance, for example by ensuring reproduction on only the left channel 32, then after the lapse of the short time interval 33 (t milliseconds) only on the right channel 34, and this alternately and/or successively for a predetermined time period 35.

The user, having then recognized this function, can completely at leisure and if so desired, act on the adjustment control 5 to adjust the stereophonic balance.

At the expiration 36 of the predetermined time period, the control unit 10 restores the stereophonic balance either to the adjustment previously in memory if there has been no modification, or retains the user-adjusted level, the value of which level has been stored for future use 37.

It is preferable to switch off the rear loud-speakers while the "balance" function is being simulated and/or adjusted.

A new actuation 40 of the function selecting control 6, either manually or eventually automatically, ensures the selection of the function for the balance between the front and rear loudspeakers (fade). In a similar way to what has been described earlier, the control unit 10 ensures via the circuit 12 the simulating 11 of a variation in the balance between the front 42 and rear 44 loudspeakers and this alternately depending on the interval 43 so that the user immediately recognizes this function. In the same way as described here-above, within a predetermined time period 46 (for example 3 seconds), the user can, by manipulating the adjustment control 5, modify if he wants so, the adjustment of this function. The eventual new value is then stored for future use 47. It is preferable to increase the volume slightly during the predetermined period 46 and while the balance between front and rear loudspeakers (fade) is being adjusted.

A new actuation 50 of the function selecting control 6 ensures the selection of the "treble level adjustment" function. In order that the user easily recognizes this function, the appropriate program located in the control unit 10 acts on the circuit 12 in order to switch the treble level to its maximum value 54 while switching the bass level to its minimum value. It is preferable to increase the volume slightly during the predetermined time period 56 and while the treble is being adjusted.

The user, having recognized this function, can, as and if he wishes, act, as described earlier, on the adjustment control 5 in order to modify the treble level. At the expiration 56 of the predetermined time period, the control unit 10 restores the treble level to that previously fixed value if there has been no adjustment, or retains it at the user-adjusted level, the value of which level has been stored for future use 57.

A new actuation 60 of the function selecting control 6 ensures the selection of the "bass level adjustment" function.

In this case, the control unit 10 acts on the circuit 12 in order to make the bass level pass to a maximum level 64 while switching the treble at its minimum value, and this, for a predetermined time period 66.

The user having then recognized the "bass level adjustment" function can, if so desired, modify the said level with the use of the adjustment control 5. If a new value is input by the user, said value is stored for future use 67.

At the expiration 66 of the predetermined time period or upon actuation of the function selecting control 6, the program is then returned to its start point, that is to say that the adjustment control 5 ensures exclusively the adjustment of the sound volume of the apparatus.

As can be easily appreciated, with such a device, the user does not need to locate a particular control from a multitude of controls, he must not turn his visual attention to a screen and thus distract his attention from driving, and finally he does not need to read the user's manual for using the apparatus.

In addition, the implementation of the device which is the subject of the invention necessitates no special or additional circuitry since it is based exclusively upon existing circuits and requires only a portion of the memory of the control circuit 10 ; the capacity of the memory can be easily increased if needed. Consequently, this device in no way increase the existing cost of apparatuses.

Provision can easily be made for the selection of the various functions and adjustments to be performed automatically, that is to say that a single actuation of the control 6 automatically ensures the simultaneous selecting of the various functions ; the user then proceeding only with the adjustment or adjustments which he desires. The device cycles through all of the adjustments without the user having to press the function selecting control 6 to advance to the next adjustment parameter. Pressing the function selecting control 6 during simulating of a function, interrupts the corresponding predetermined time period (36, 46, 56, 66) and immediately advances the program to the simulating of the next function.

Moreover, rather than varying, in view of their recognition, the various adjustments or functions between their maximum and minimum levels, they can advantageously be varied between two pre-established levels. In fact, in the case of small dimension loud-speakers such as those mounted in vehicles, an adjustment of the bass level to the maximum and/or the treble to the minimum values generates a saturation or unpleasant noise which should absolutely be avoided.

An alternative to using time intervals is to measure the cyclic variations by the number of cycles performed. Additionally, the method used to input the functions selecting control 6 and the function adjustment control 5 is not critical, and may be made by manual, audio, or remote input mechanisms. Both the function selecting control and the function adjustment control may be provided by a single means.

## Claims

1. Method for assisting a user to recognize selected functions of an audio/video reproduction apparatus comprising : a function selecting control (6) for selecting functions, an adjustment control (5) for adjusting the selected function to a user-desired level, a control unit (10) automatically ensuring the execution of instructions which are pre-established for the apparatus, a circuit (12) permitting the adjustment of the various functions associated with means (14, 16) of audio/video reproduction, characterized in that, it includes identifying the function to a user by means (11) which automatically simulate the actual function through an accentuation and/or an alternate attenuation of said function between pre-established levels thereby enabling the user to recognize the function and thus permit its adjustment to a desired level.

2. Method according to claim 1, characterized in that the simulating means (11) control the audio reproductions means (14, 16) so that the pre-establised levels and thus the selected functions are audibly perceptible.

3. Method according to claim 1, characterized in that actuation of the function selecting control (6) automatically initiates said simulating means (11) for each of the functions.

4. Method according to claim 1, characterized in that actuation of the function selecting control (6) during a function simulation sequence automatically powers simulation of the next function.

5. Method according to claim 1, characterized in that the simulation of a function is carried out for a pre-established number of times.

6. Method according to claim 1, characterized in that the simulation of a function is carried-out cyclically for a predetermined period.

7. Method according to claim 1, characterized in that the adjustment of the selected function is permitted within a pre-established time period.

8. Method according to claim 1, characterized in that the simulating means (11) ensures identification of a function by automatically emphasizing it while de-emphasizing its complementary function.

9. Device permitting perception of the nature of a selected function of an audio-video reproduction apparatus comprising : a function selecting control (6) for selecting functions, an adjustment control (5) for adjusting the selected function to a user-desired value, a control unit (10) automatically enabling the execution of instructions which are pre-established for the apparatus, a circuit (12) permitting the adjustment of the various functions associated with means (14, 16) of audio/video reproduction, characterized in that, the control unit (10) further comprises simulating means (11) permitting automatic triggering of a sequence of prerecorded instructions upon actuation of the function selecting control (6), the result of this sequence of instructions being an accentuation and/or an alternate attenuation of the selected function between pre-established levels.

10. Device according to claim 9, characterized in that the sequence of instructions for the simulating means (11) is processed by the audio circuit (12) so that the function is audibly perceptible by the user.

## Patentansprüche

1. Verfahren zur Unterstützung eines Benutzers zur Erkennung ausgewählter Funktionen eines Audio/Video-Wiedergabegerätes umfassend: ein Funktionsauswahlbedienelement (6) zur Funktionsauswahl, ein Einstellbedienelement (5) zur Einstellung der gewählten Funktionen auf einen vom Benutzer gewünschten Pegel, eine Steuereinheit (10), die die Ausführung von für das Gerät vorbestimmten Befehlen automatisch sicherstellt, eine Schaltung (12), die die Einstellung der verschiedenen mit Mitteln (14, 16) der Audio/Video-Wiedergabe verbundenen Funktionen gestattet,
dadurch **gekennzeichnet**, daß
es die Identifizierung der Funktion für den Benutzer beinhaltet durch Mittel (11), welche automatisch die eigentliche Funktion simulieren durch eine Hervorhebung und/oder eine abwechselnde Abschwächung der Funktion zwischen vorbestimmten Pegeln, wodurch der Benutzer in die Lage versetzt wird, die Funktion zu erkennen und daher ihre Einstellung auf einen gewünschten Pegel erlaubt wird.

2. Verfahren nach Anspruch 1,
dadurch **gekennzeichnet**, daß
die Simulationsmittel (11) die Audio-Wiedergabemittel (14, 16) steuern, so daß die vorbestimmten Pegel und daher die ausgewählten Funktionen akustisch wahrnehmbar sind.

3. Verfahren nach Anspruch 1,
dadurch **gekennzeichnet**, daß
die Betätigung des Funktionsauswahlbedienelements (6) automatisch die Simulationsmittel (11) für jede der Funktionen auslöst.

4. Verfahren nach Anspruch 1,
dadurch **gekennzeichnet**, daß
eine Betätigung des Funktionsauswahlbedienelements (6) während einer Funktions-Simulationssequenz automatisch die Simulation der nächsten Funktion betreibt.

5. Verfahren nach Anspruch 1,
dadurch **gekennzeichnet**, daß
die Simulation einer Funktion eine vorgegebene Anzahl von Malen durchgeführt wird.

6. Verfahren nach Anspruch 1,
dadurch **gekennzeichnet**, daß
die Simulation einer Funktion zyklisch ausgeführt wird während einer vorbestimmten Zeitspanne.

7. Verfahren nach Anspruch 1,
dadurch **gekennzeichnet**, daß
die Einstellung der gewählten Funktion innerhalb einer vorbestimmten Zeitspanne gestattet ist.

8. Verfahren nach Anspruch 1,
dadurch **gekennzeichnet**, daß
das Simulationsmittel (11) die Erkennung einer Funktion dadurch sicherstellt, daß sie sie automatisch betont, während sie ihre komplementäre Funktion abschwächt.

9. Vorrichtung, welche die Wahrnehmung der Art einer ausgewählten Funktion eines Audio/Video-Wiedergabegerätes erlaubt, umfassend: ein Funktionsauswahlbedienelement (6) zur Funktionsauswahl, ein Einstellbedienelement (5) zur Einstellung der ausgewählten Funktionen auf einen vom Benutzer gewünschten Wert, eine Steuereinheit (10), welche die Ausführung von für das Gerät vorbestimmten Befehlen automatisch ermöglicht, eine Schaltung (12), welche die Einstellung der verschiedenen, mit den Mitteln (14, 16) der Audio/Video-Wiedergabe verbundenen Funktionen erlaubt,
dadurch **gekennzeichnet**, daß
die Steuereinheit (10) weiterhin Simulationsmittel (11) umfaßt, welche die automatische Auslösung einer Sequenz aufgezeichneter Befehle erlaubt nach der Betätigung des Funktionsauswahlbedienelements (6), wobei das Ergebnis dieser Sequenz von Befehlen eine Hervorhebung und/oder eine abwechselnde Abschwächung der gewählten Funktion zwischen vorgegebenen Pegeln ist.

10. Vorrichtung nach Anspruch 9,
dadurch **gekennzeichnet**, daß
die Sequenz an Befehlen für die Simulationsmittel (11) durch eine Audioschaltung (12) verarbeitet wird, so daß die Funktion akustisch wahrnehmbar ist für den Benutzer.

## Revendications

1. Méthode pour aider un utilisateur à reconnaître les fonctions choisies d'un appareil de reproduction audio/vidéo comprenant : une commande de sélection de fonctions (6) pour sélectionner les fonctions, une commande de réglage (5) pour régler la fonction sélectionnée au niveau souhaité par l'utilisateur, une unité de contrôle (10) assurant automatiquement l'exécution d'instructions préétablies pour l'appareil, un circuit (12) permettant le réglage des différentes fonctions associé à des moyens (14, 16) de reproduction audio/vidéo, caractérisée en ce qu'elle assure l'identification de la fonction par l'utilisateur à l'aide de moyens (11) qui automatiquement simulent la fonction mise en oeuvre par une accentuation et/ou une atténuation alternée de ladite fonction entre des niveaux préétablis, permettant ainsi à l'utilisateur de reconnaître cette fonction et de la régler au niveau souhaité.

2. Méthode selon la revendication 1, caractérisée en ce que les moyens de simulation (11) contrôlent les moyens de reproduction audio (14, 16) de telle façon que les niveaux préétablis et donc les fonctions sélectionnées soient reconnus de façon audible.

3. Méthode selon la revendication 1, caractérisée en ce que la manipulation de la commande de sélection de fonctions (6) met automatiquement en oeuvre lesdits moyens de simulation (11) pour chacune des fonctions.

4. Méthode selon la revendication 1, caractérisée en ce qu'une manipulation de la commande de sélection des fonctions (6) pendant une séquence de simulation d'une fonction met automatiquement en oeuvre la simulation de la fonction suivante.

5. Méthode selon la revendication 1, caractérisée en ce que la simulation d'une fonction est mise en oeuvre un nombre de fois prédéterminé.

6. Méthode selon la revendication 1, caractérisée en ce que la simulation d'une fonction est mise en oeuvre pendant un laps de temps prédéterminé.

7. Méthode selon la revendication 1, caractérisée en ce que le réglage de la fonction sélectionnée est autorisé pendant un laps de temps prédéterminé.

8. Méthode selon la revendication 1, caractérisée en ce que les moyens de simulation permettent l'identification d'une fonction en accentuant celle-ci et atténuant la fonction complémentaire et ce automatiquement.

9. Dispositif permettant la perception de la nature d'une fonction sélectionnée d'un appareil de reproduction audio/vidéo comprenant : une commande de sélection de fonctions (6) pour sélectionner les fonctions, une commande de réglage (5) pour régler la fonction sélectionnée à une valeur souhaitée par l'utilisateur, une unité de contrôle (10) assurant automatiquement l'exécution d'instructions préétablies pour l'appareil, un circuit (12) permettant le réglage des différentes fonctions associé à des moyens de reproduction (14, 16) audio/vidéo, caractérisé en ce que l'unité de contrôle (10) comprend en outre des moyens de simulation (11) permettant le déclenchement automatique d'une séquence d'instructions pré-enregistrées lors d'une manipulation de la commande de sélection de fonctions (6), le résultat de cette séquence étant une accentuation et/ou une atténuation alternée de la fonction sélectionnée entre des niveaux préétablis.

10. Dispositif selon la revendication 9, caractérisé en ce que la séquence d'instructions pour les moyens de simulation (11) est mise en oeuvre par le circuit audio (12) de sorte que la fonction soit perçue de façon audible par l'utilisateur.
